# EUROPEAN PATENT APPLICATION

(11) **EP 4 412 407 A1**
(43) Date of publication of application: **07.08.2024**
(21) Application number: 23154361.2
(22) Date of filing: 31.01.2023
(51) Int. Cl.: H05K 1/05, H05K 1/02, H05K 1/18, H05K 1/11, H05K 3/00

(54) **ISOLATED METALLIC SUBSTRATE PRINTED CIRCUIT BOARD FOR AN AUTOMOTIVE LUMINOUS DEVICE AND AUTOMOTIVE LUMINOUS DEVICE**

(71) Applicant: VALEO VISION, 93012 Bobigny Cedex (FR)
(72) Inventor: CANTUDO FRANCO, Miguel Angel, 23600 MARTOS (ES); ROLDAN ZAFRA, Jose David, 23600 MARTOS (ES)
(74) Representative: Valeo Visibility

(57) **Abstract**

The invention is referred to an Isolated metallic substrate printed circuit board (1) for an automotive luminous device. The printed circuit board (1) is bended by a bending portion (5), in such a way that the printed circuit board comprises a first plane portion (6), the bending portion (5) and a second plane portion (7) which forms an angle with the first plane portion (6). The first portion (6) comprises a connection portion (8) which is configured to receive an electric connector (11). The connection portion (8) comprises a plurality of electric tracks, which are deposited on the track layer (4) of the connection portion (8). The second portion comprises a solid-state light source (9) arranged on the track layer (4). The connection portion (8) and the solid-state light source (9) are in electric connection by means of electric tracks which run along the track layer (4) of the first portion (6), the bending portion (5) and the second portion (7).

## Description

### TECHNICAL FIELD

This invention belongs to the field of lighting devices installed in automotive vehicles, and more specifically to the electronic assemblies used in these automotive lighting devices.

### STATE OF THE ART

Automotive lighting market can be considered one of the most competitive ones and new lighting functionalities are constantly required.

Current trends try to provide smaller devices, so it is important to detect those elements which are not necessary or the size of which may be reduced in order to obtain a smaller final result.

However, functionality requirements are still present, and features like watertightness, electro-static discharges (ESD) protection and reliability should be ensured despite the improvements in other areas.

In fact, one of the most critical questions is electric connection between elements. Advanced lighting functions require a great amount of wire harnesses and connectors. These elements are inside the devices and may entangle or improperly connect. Performing connections in narrow scenarios is sometimes a big challenge.

When printed circuit boards are small and the rest of the housing is full of elements, further hollows and operations must be performed on the housing, making it difficult to design and mould these parts.

It is therefore a challenge to reduce the size of the lighting devices but without compromising the quality. A solution for this problem is therefore sought.

### DESCRIPTION OF THE INVENTION

The invention provides an alternative solution for improving the aforementioned problem by an electronic assembly and an automotive lighting device. Preferred embodiments of the invention are also presented in this section.

In a first inventive aspect, the invention provides an isolated metallic substrate printed circuit board for an automotive luminous device, the printed circuit board comprising a metallic substrate, a first electrically isolating layer and a first track layer, wherein
the printed circuit board is bended by a bending portion, in such a way that the printed circuit board comprises a first plane portion, a bending portion and a second plane portion which forms an angle with the first plane portion
the first portion comprises a connection portion which is configured to receive an electric connector
the connection portion comprises a plurality of electric tracks, which are deposited on the first track layer of the connection portion
the second portion comprises a solid-state light source arranged on the first track layer
the connection portion and the solid-state light source are in electric connection by means of electric tracks which run along the first track layer of the first portion, the bending portion and the second portion.

With this printed circuit board, there is no need to perform difficult operations to connect an electric connection in the connection portion of the printed circuit board when this printed circuit board is inserted into the housing of an automotive lighting device. Since it is bended, the first portion is oriented in a different direction than the second portion, so the connector is inserted in a direction different to the plane of the second plane portion. The first plane portion outstands from the plane of the second plane portion, making the electric connection easier. The bending portion means that there is a printed circuit board which is bended: the first plane portion extends from one end of the bending portion and the second plane portion extends from the opposite end of the bending portion. In other words, all the possible paths traced on the bending portion between both ends are curved. Hence, the second plane portion forms an angle with respect to the first plane portion. Advantageously, each plane portion is tangentially connected to the bending portion.

Advantageously, the metallic substrate has a form of a sheet presenting a first and a second main opposite faces, in particular parallel faces, joined an edge.

The first electrically isolating layer is installed on the first main face of the metallic substrate, and the first track layer is installed on the first electrically isolating layer.

The term "solid state" refers to light emitted by solid-state electroluminescence, which uses semiconductors to convert electricity into light. Compared to incandescent lighting, solid state lighting creates visible light with reduced heat generation and less energy dissipation. The typically small mass of the solid-state electronic lighting components provides for greater resistance to shock and vibration compared to brittle glass tubes/bulbs and long, thin filament wires. They also eliminate filament evaporation, potentially increasing the life span of the illumination device. Some examples of these types of lighting comprise semiconductor light-emitting diodes (LEDs), organic light-emitting diodes (OLED), or polymer light-emitting diodes (PLED) as sources of illumination rather than electrical filaments, plasma or gas.

In some particular embodiments, the connection portion of the first portion is configured to receive a card edge connector.

A card edge connector is easy and direct to insert, which is advantageously connected to the feature of the different orientation of the first portion.

In some particular embodiments, the second plane portion forms an angle with the first plane portion), the angle being comprised between 70º and 110º, preferably between 85º and 95º.

When the second portion is almost perpendicular, thermal performance is also advantageous with respect to a plane substrate.

In some particular embodiments, at least one solid-state light source is configured to emit light in an emission direction which forms an angle of less than 50º with the first plane portion.

The emission direction represents the axis for the maximum intensity emission, and the total light emission is comprised within a light cone containing this emission direction.

When the printed circuit board is placed in its final position in the housing of an automotive lighting device, the solid-state light sources are oriented towards the interior of the housing, and the first connector is also oriented towards the interior of the housing, to perform the electric control. Hence, this common orientation of both elements is advantageous, since it makes the connection and operation easier.

In some particular embodiments, the isolated metallic substrate printed circuit board further comprises a second electrically isolating layer installed on at least a portion of the metallic substrate and a second track layer installed on the second electrically isolating layer.

In some particular embodiments, the second electrically isolating layer is installed on the second main face of the metallic substrate.

With this feature, some electronic components may be located on the opposite side of the light sources.

In some particular embodiments, the second electrically isolating layer covers all the second main face of the metallic substrate.

In these embodiments, a greater surface is available to place more electronic components.

In some particular embodiments, the isolated metallic substrate printed circuit board according further comprises a heatsink element attached to the metallic substrate, in particular to the second main face of the metallic substrate.

This heatsink element attached to the metallic substrate, which is oriented in a direction opposite to the light sources, is suitable for evacuating the heat produced in the printed circuit board, since the contact between two metallic parts produces a good thermal dissipation.

In some particular embodiments, the radius of curvature of the bending portion is comprised between 1.5 mm and 20 mm.

The bending portion is the portion of the printed circuit board which is bended, i.e., which is not plane. In most cases, where this bended portion has the shape of a portion of a cylinder, the radius of curvature is therefore the radius of the cylinder which is tangent to this bended portion. This can be achieved due to the nature of the isolated metallic substrate printed circuit board. In other embodiments, the bending portion may have a different shape, for example, a portion of a cone. This shape would allow different relative orientations between the first and the second plane portions. In this case, the radius of curvature should be understood as the largest one along the conical surface, when measured perpendicularly to the axis of rotational symmetry of the cone. The radius of curvature is measured from the main face which is the nearest from the center of curvature.

In some particular embodiments, the solid-state light source is arranged on the first track layer by means of a solder mask.

A solder mask is a suitable connection for light sources, especially in isolated metallic substrate printed circuit boards.

In some particular embodiments, the metallic substrate comprises aluminum and/or an aluminum alloy.

This is advantageous for several reasons: firstly for mechanical reasons, since aluminum is ductile. Also for thermal dissipation, since metals has a high heat conductivity.

In some particular embodiments, the second portion has a surface which is greater than the surface of the first portion.

In a further inventive aspect, the invention provides an automotive lighting device comprising
a housing comprising a hole;
an electric connector arranged inside the housing;
an isolated metallic substrate printed circuit board according to the present invention, wherein at least a portion of the first portion of the isolated metallic substrate printed circuit board is introduced inside the housing through the hole; and
a sealing element arranged between the electric layer of the isolated metallic substrate printed circuit board and a portion of the housing surrounding the hole;
wherein the electric connector is coupled to the connection portion of the isolated metallic substrate printed circuit board.

The housing of such a device does not need additional hollow portions to receive the connection of the printed circuit board, since the first portion of the printed circuit board is oriented towards the interior of the lighting device, while the second portion of the same may be used as a cap with the interposition of a sealing element, such as a gasket.

In this case, the isolated metallic substrate printed circuit board is oriented so that the light sources emit light in a direction from the hole to the printed circuit board towards the outside of the lighting device.

In some particular embodiments, when the printed circuit board is oriented into position, the hole is covered by the second portion, while the first portion is the portion which enters inside the housing.

In some particular embodiments, the automotive lighting device further comprises an optical element suitable for receiving light emitted by the light source and for shaping the light into a light pattern projected outside the lighting device.

In some particular embodiments, the electric connector is fixed to a structure of the housing, in such a way that the electric connector offers a response force when the connection portion of the isolated metallic substrate printed circuit board is pressed against the electric connector.

With this arrangement, the printed circuit board, used as a cap, may be directly presented towards the housing, and plugging the connector in the same action as closing the hole in the housing with the interposition of the sealing element, thus achieving connection and closing in the same action.

### BRIEF DESCRIPTION OF THE DRAWINGS

To complete the description and in order to provide for a better understanding of the invention, a set of drawings is provided. Said drawings form an integral part of the description and illustrate an embodiment of the invention, which should not be interpreted as restricting the scope of the invention, but just as an example of how the invention can be carried out. The drawings comprise the following figures:
Figure 1 shows a transverse cut of a portion of an isolated metallic substrate printed circuit board according to the invention.
Figure 2 shows a complete view of an isolated metallic substrate printed circuit board according to the invention and a connector connected thereto.
Figure 3 shows a complete view of an arrangement of an isolated metallic substrate printed circuit board according to the invention and a heatsink attached thereto.
Figure 4 shows a perspective view of the installation of a printed circuit board according to the invention in an automotive lighting device.
Figure 5 shows an automotive lighting device according to the invention installed in an automotive vehicle.

In these figures, the following reference numbers are used
- 1: Printed circuit board
- 2: Metallic substrate
- 3: First electrical isolating layer
- 4: First track layer
- 5: Bending portion
- 6: First plane portion
- 7: Second plane portion
- 8: Connection portion
- 9: LED
- 10: Headlamp
- 11: Card edge connector
- 12: Heatsink
- 13: Housing
- 14: Hole of the housing
- 15: Gasket

### DETAILED DESCRIPTION OF THE INVENTION

The example embodiments are described in sufficient detail to enable those of ordinary skill in the art to embody and implement the systems and processes herein described. It is important to understand that embodiments can be provided in many alternate forms and should not be construed as limited to the examples set forth herein.

Accordingly, while embodiment can be modified in various ways and take on various alternative forms, specific embodiments thereof are shown in the drawings and described in detail below as examples. There is no intent to limit to the particular forms disclosed. On the contrary, all modifications, equivalents, and alternatives falling within the scope of the appended claims should be included. Elements of the example embodiments are consistently denoted by the same reference numerals throughout the drawings and detailed description where appropriate.

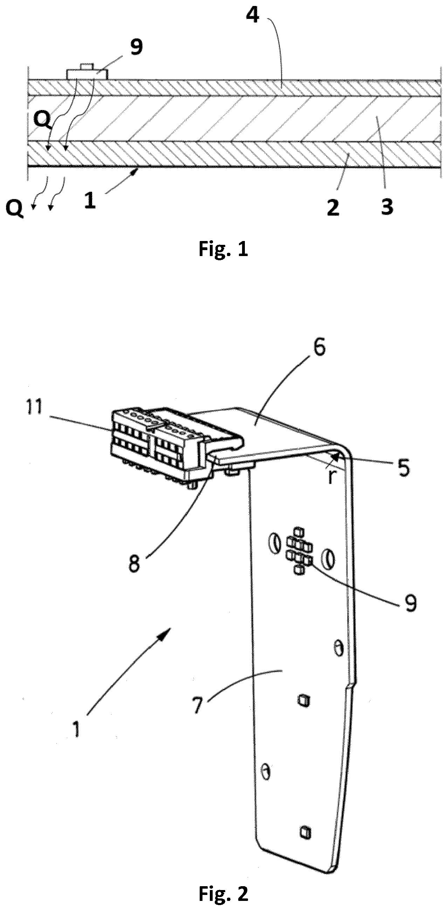

Figure 1 shows a transverse cut of a portion of an isolated metallic substrate printed circuit board 1 according to the invention.

This printed circuit board 1 comprises a metallic substrate 2, for example made of aluminum and/or an aluminum alloy, a first electrically isolating layer 3 and a first track layer 4. The metallic substrate 2 comports a first and a second main opposite faces. On Figure 1, the first main face is the upper one and the second main face is the lower one. The first electrically isolating layer 3 is installed on the first main face of the metallic substrate 2, and the first track layer is installed on the first electrically isolating layer. In other words, the first electrically isolating layer 3 is arranged between the metallic substrate 2 and the first track layer 4. The first track layer 4 comprises one or more LEDs 9 (only one of them is shown in this figure, although the printed circuit board could comprise more than one) arranged on the first track layer 4.

In this figure, it is clearly shown how the heat Q generated by the LEDs 9 is transmitted by conduction to the different layers until arriving at the metallic substrate 2 and then, evacuated to the exterior by a convective process. The isolating layer 3 avoids that a short circuit may happen because, without its interposition, the metallic substrate 2 would be in contact with all the electric tracks. In some cases, a second electrically isolating layer is deposited on a portion of the metallic substrate 2, for example on the second main face, and then, a second track layer is deposited on this second electrically isolating layer. Hence, additional electric components may be installed on the opposite face compared to the LEDs 9. The fact that they are installed only over a portion may be due to the presence of a heatsink installed over a different portion of the metallic substrate 2. Such a heatsink is described in Figure 2.

Figure 2 shows a complete view of an isolated metallic substrate printed circuit board 1 according to the invention.

In this view, it is appreciated how the printed circuit board 1 is bended. This bending is performed in a bending portion 5, leaving a first plane portion 6 and a second plane portion 7, which forms an angle of 90° with respect to the first plane portion 6. This means that the first plane portion 6 extends from one end of the bending portion 5 and the second plane portion 7 extends from the opposite end of the bending portion 5. Hence, the second plane portion 7 forms an angle with respect to the first plane portion 6, which in this case is 90º. Of course, other value are possible for this angle.

The first portion 6 comprises a connection portion 8 which is configured to receive an electric card edge connector 11. Electric tracks extend along the first track layer 4 from this connection portion 8 to the LEDs 9, which are located in the second portion 7. Hence, these electric tracks run from the first portion 6 to the second portion 7, and cross the bending portion 5.

The LEDs 9 are intended to emit light in an emission direction which is substantially parallel to the plane of the first plane portion.

The radius of curvature r of the bending portion 5 is aproximately 2 mm, so that the bending portion 5 does not take an excessive room in the housing. The bending portion is the portion of the printed circuit board which is bended, i.e., which is not plane. Therefore, the radius of curvature is the radius of the cylinder which would be tangent to this bended portion.

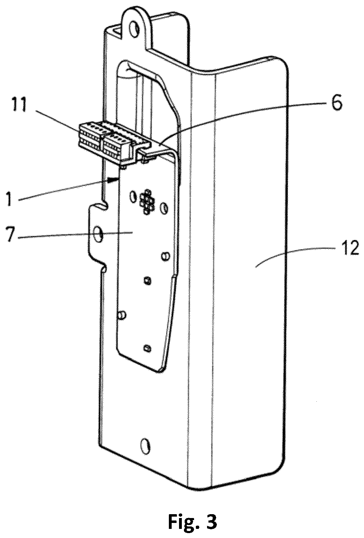

Figure 3 shows a perspective view of an arrangement of an isolated metallic substrate printed circuit board according to the invention and a heatsink attached thereto.

The printed circuit board 1 further comprises a heatsink 12 element attached to the metallic substrate 2, to enhance the heat dissipation of the assembly. The heatsink 12 is attached to the second main face of the metallic substrate 2, i.e. the side of the printed circuit board which is opposite to the arrangement of the LEDs, so that the attachment of the heatsink 12 does not affect to the emission of light.

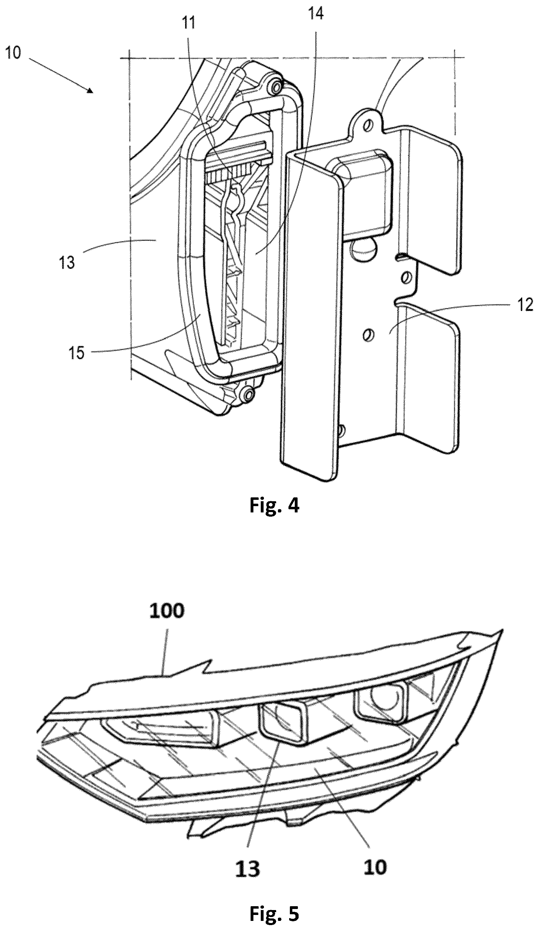

Figure 4 shows a perspective view of the installation of such a printed circuit board 1 in a headlamp.

The headlamp 10 comprises a housing 13 with a hole 14 and an electric connector, here a card edge connector 11, arranged inside the housing 13.

The connection portion 8 of the first portion 6 of the printed circuit board 1 is intended to be connected to the card edge connector 11. This card edge connector 11 is fixed to a structure of the housing 13, in such a way that the electric connector 11 offers a response force when the connection portion 8 of the isolated metallic substrate printed circuit board 1 is pressed against the electric connector 11. Hence, the printed circuit board 1 may be pressed against the connector 11 without holding the electric connector 11, making it unnecessary to provide a spare portion of harness to create the connection outside the housing and then introducing the spare portion of harness inside the housing.

Hence, when the first portion 6 of the printed circuit board 1 is placed in its final position inside the housing 13 and connected to the connector 11, a gasket 15 is interposed between the first track layer - which is the layer facing to the hole 14 of the housing 13 - and the housing 13, thus creating a watertight closure for the housing in this zone.

In order to ensure a good fixation of the printed circuit board 1 onto the housing 13, and a compression of the gasket 15 suitable for ensuring the watertightness, the heatsink 12 may comport fixation zones adapted to be positioned relative to fixation zones on the housing 13. For example, on Figure 4, the two areas around the holes visible on the top and on the bottom of the heatsink 12 may come into contact respectively with the two circular portions visible over and under the hole 14. Then, the heatsink may be fixed onto the housing by screwing screws into said holes of the heatsink 12 and into said circular portions.

Although not seen in this figure, since this figure is taken from the rear portion of the headlamp, to show the insertion of the printed circuit board on the hole, the headlamp also comprises an optical element to project the light emitted by the LED of the printed circuit board. In some cases, the optical element comprises one or more than one reflectors suitable for receiving light emitted by the LED and for shaping the light into a light pattern projected outside the headlamp 10. The optical element may also comprise one or several lenses, or even a combination of one or more reflectors and one or more lenses, so that the intended final light pattern is achieved.

Figure 5 shows a headlamp 10 comprising the printed circuit board assembly shown in previous figures installed in an automotive vehicle 100. On Figure 5, only a small portion of the automotive vehicle 100 is represented. This portion directly surrounds the headlamp 10. In this case, the automotive lighting device is a headlamp 10, although the present invention may be applied to other type of devices, such as signal lamps, rearlamps, fog lamps or interior lighting devices.

This headlamp has a housing with a hole in its rear portion (this is the reason why it is not visible in this figure, it was visible in Figure 4), and the printed circuit board assembly is installed through this hole. It also has a front aperture, which is closed by the outer lens. This outer lens is configured to transmit at least a part of the light emitted by the LEDs of the printed circuit board.

## Claims

1. Isolated metallic substrate printed circuit board (1) for an automotive luminous device, the printed circuit board comprising a metallic substrate (2), a first electrically isolating layer (3) and a first track layer (4), wherein
the printed circuit board (1) is bended by a bending portion (5), in such a way that the printed circuit board comprises a first plane portion (6), the bending portion (5) and a second plane portion (7) which forms an angle with the first plane portion (6);
the first portion (6) comprises a connection portion (8) which is configured to receive an electric connector (11);
the connection portion (8) comprises a plurality of electric tracks, which are deposited on the first track layer (4) of the connection portion (8);
the second portion comprises a solid-state light source (9) arranged on the first track layer (4);
the connection portion (8) and the solid-state light source (9) are in electric connection by means of electric tracks which run along the first track layer (4) of the first portion (6), the bending portion (5) and the second portion (7).

2. Isolated metallic substrate printed circuit board according to claim 1, wherein the connection portion (8) of the first portion (6) is configured to receive a card edge connector (11).

3. Isolated metallic substrate printed circuit board according to any of the preceding claims, wherein the second plane portion (7) forms an angle with the first plane portion (6), the angle being comprised between 70º and 110º, preferably between 85º and 95º.

4. Isolated metallic substrate printed circuit board according to any of the preceding claims, wherein the at least one solid-state light source (9) is configured to emit light in an emission direction which forms an angle of less than 50º with the first plane portion.

5. Isolated metallic substrate printed circuit board according to any of the preceding claims, further comprising an second electrically isolating layer installed on at least a portion of the second main face of the metallic substrate (2) and a second track layer installed on the second electrically isolating layer.

6. Isolated metallic substrate printed circuit board according to claim 5, wherein the second electrically isolating layer covers all the second main face of the metallic substrate.

7. Isolated metallic substrate printed circuit board according to any of claims 1 to 5, further comprising a heatsink (12) element attached to the metallic substrate (2), in particular to the second main face of the metallic substrate (2).

8. Isolated metallic substrate printed circuit board according to any of the preceding claims, wherein the radius of curvature of the bending portion (5) is comprised between 1.5 mm and 20 mm.

9. Isolated metallic substrate printed circuit board according to any of the preceding claims, wherein the solid-state light source (9) is arranged on the first track layer (4) by means of a solder mask.

10. Isolated metallic substrate printed circuit board according to any of the preceding claims, wherein the metallic substrate (2) comprises aluminum and/or an aluminum alloy.

11. Isolated metallic substrate printed circuit board according to any of the preceding claims, wherein the second portion (7) has a surface which is greater than the surface of the first portion (6).

12. Automotive lighting device (10) comprising
a housing (13) comprising a hole (14);
an electric connector (11) arranged inside the housing (13);
an isolated metallic substrate printed circuit board (1) according to any of the preceding claims, wherein at least a portion of the first portion (6) of the isolated metallic substrate printed circuit board (1) is introduced inside the housing (13) through the hole (14);
a sealing element (15) arranged between the first track layer (4) of the isolated metallic substrate printed circuit board (1) and a portion of the housing surrounding the hole (14);
wherein the electric connector (11) is coupled to the connection portion of the isolated metallic substrate printed circuit board (1).

13. Automotive lighting device (10) according to claim 12, further comprising an optical element suitable for receiving light emitted by the light source (9) and for shaping the light into a light pattern projected outside the lighting device (10).

14. Automotive lighting device (10) according to any of claims 12 or 13, wherein the electric connector (11) is fixed to a structure of the housing (13), in such a way that the electric connector (11) offers a response force when the connection portion of the isolated metallic substrate printed circuit board (1) is pressed against the electric connector (11).
